# EUROPEAN PATENT SPECIFICATION

(11) **EP 0 956 516 B1**
(45) Date of publication and mention of the grant of the patent: **10.04.2002**
(21) Application number: 97908608.9
(22) Date of filing: 29.01.1997
(51) Int. Cl.: G03F 1/08, G03F 7/20

(54) **METHOD AND APPARATUS FOR THE PRODUCTION OF A STRUCTURE BY FOCUSED LASER RADIATION ON A PHOTOSENSITIVELY COATED SUBSTRATE**
VERFAHREN UND GERÄT ZUR ERZEUGUNG EINES MUSTERS AUF EINEM MIT FOTORESIST BESCHICHTETEN SUBSTRAT MITTELS FOKUSIERTEM LASERSTRAHL
PROCEDE ET DISPOSITIF DE PRODUCTION D'UNE STRUCTURE PAR RAYONNEMENT LASER CONCENTRE SUR UN SUBSTRAT A REVETEMENT PHOTOSENSIBLE

(43) Date of publication of application: 17.11.1999
(73) Proprietor: MICRONIC LASER SYSTEMS AB, S-18303 Täby (SE)
(72) Inventor: SANDSTRÖM, Torbjörn, S-435 43 Mölnlycke (SE); THUREN, Anders, S-183 72 Täby (SE)
(74) Representative: Lindberg, Klas Valter Bo
(86) International application number: SE9700134
(87) International publication number: WO9833096

(56) References cited:
- WO-A-90/15714
- US-A- 5 221 422

## Description

### BACKGROUND OF THE INVENTION

### 1. Field of the Invention

The invention relates to a surface pattern produced on photosensitively coated substrate by a focused laser beam, and method and an apparatus for producing such a pattern. In particular, the invention is directed to methods and apparatus for producing structures of chromium on glass which are suitable for use as masks or reticles for photolithography in semiconductor production.

### 2. Earlier problems

Masks and what are known as reticles with extremely accurate structures of chromium on glass substrates are used for the production of photolithographic structures or patterns in the production of semiconductors. A 5X reticle, that is to say a pattern or structure which is photographically reduced five fold on to the semiconductor wafer and which constitutes the most widespread type of mask in the near future may comprise a quartz plate measuring 150 mm x 150 mm which has a structure of opaque chromium. The structure is formed by exposure to light or an electron beam of a photosensitive or electron-sensitive covering on the chromium film. The photosensitive or electron-sensitive covering is then chemically developed and the exposed part thereof is removed. In a subsequent etching operation, the chromium is etched away at the locations at which the covering has been removed and the chromium film which remains forms the pattern or structure.

The smallest line widths of known 5-fold reticles are about 2 microns. However the required level of accuracy is considerably higher. Admissible overlay errors, that is to say the admissible difference between the position of the edges of the chromium in identical reticles produced in two successive steps is to be of the order of magnitude of 0.05 micron.

Reticles are mainly used for the production of accurate structures or patterns in the semiconductor industry. However there are also many other applications, for example in the field of integrated optics, diffraction optics, computer-generated holograms, micro-machining of miniaturized sensors, optical information storage and superconducting devices. Other important applications are direct exposure of patterns on semiconductor wafers and pattern generation for large-area displays. The high costs of existing production equipment for surface patterns or structures with a sufficient degree of accuracy and in particular using electron beam reticle writers represent an obstacle to the development of new equipment in these little established areas, in particular in universities and smaller companies.

A common aspect of all known pattern generators is that the mask or reticle is described in a digital data bank containing a list of all structure or pattern elements with their geometrical data. Before the structures are written, the geometrical data are converted to the format which is used by the writing hardware. During that conversion operation the geometrical co-ordinates are truncated to the addressing resolution of the hardware, that is to say the writing address grid.

Most modern pattern generators use a raster scan principle with a scanning beam which is either an electron beam or a laser beam and which is deflected along parallel lines on the substrate which is covered with a radiation-sensitive covering. The beam is switched on and off in dependence on a bitmap for the structure, which is stored in the control system. Another option is that the beam is produced during a writing time which is derived from data stored in an intermediate compressed format.

For a pattern or surface structure with an address grid or raster of 0.5 micron, it is possible to produce a bitmap with a bit for each grid point, a digital bit for each pixel, i.e., each individually controllable area element.

In principle a pattern with an addressability of 0.05 micron could also be written with scan lines at a spacing of 0.05 micron and with a pixel spacing of 0.05 micron along the scan line. However a bitmap with a 0.05 micron grid and a surface cover rate as referred to above corresponds to a data rate of 2-4 Gbits per second. It is not possible to modulate a single writing beam at that rate. In addition the data volume is one hundred times greater than for the 0.5 micron grid and is fairly unmanageable. Even real-time expansion from the compressed data format is impracticable as the flow of data would choke the data buses of most processors. Technological limitations in regard to modulation rate and data flow would severely limit the writing speed and make it impossible to use a reticle writer with a full pixel map with a 0.05 micron address grid.

### 3. Solution to earlier problems and description of prior art

An method and an apparatus to solve the above mentioned problems was presented by the inventor of the present invention in DE-A-4022732. This method and this apparatus will be described in detail below. The apparatus includes data delivery means for controlling the input of said modulator while the laser beam is scanning. Generally, the data delivery means includes a clock having a predetermined clock period between clock pulses, so as to establish a regular train of clock pulses. A data processing unit is also provided for accepting input data and computing or establishing beam intensity data and beam position data for an edge in the pattern. Both the beam intensity data and the beam position data are established in a digital format. The apparatus also includes as part of the data delivery means a signal processing unit for converting the beam position data to an equivalent time for positioning the laser beam along the scan line during scanning. Particularly, this equivalent time is converted as an integer number of clock pulses plus a fractional remainder. To create a time pulse corresponding to the equivalent time, digital counting means may be provided for generating a timing pulse at a time corresponding to the integer number of clock pulses and a time delay circuit may be provided for incurring to the timing pulse a time delay equal to the fractional remainder. Once the corresponding time pulse is created, a circuit may be used for setting the modulator input signal to the digital beam intensity data at the arrival of the timing pulse.

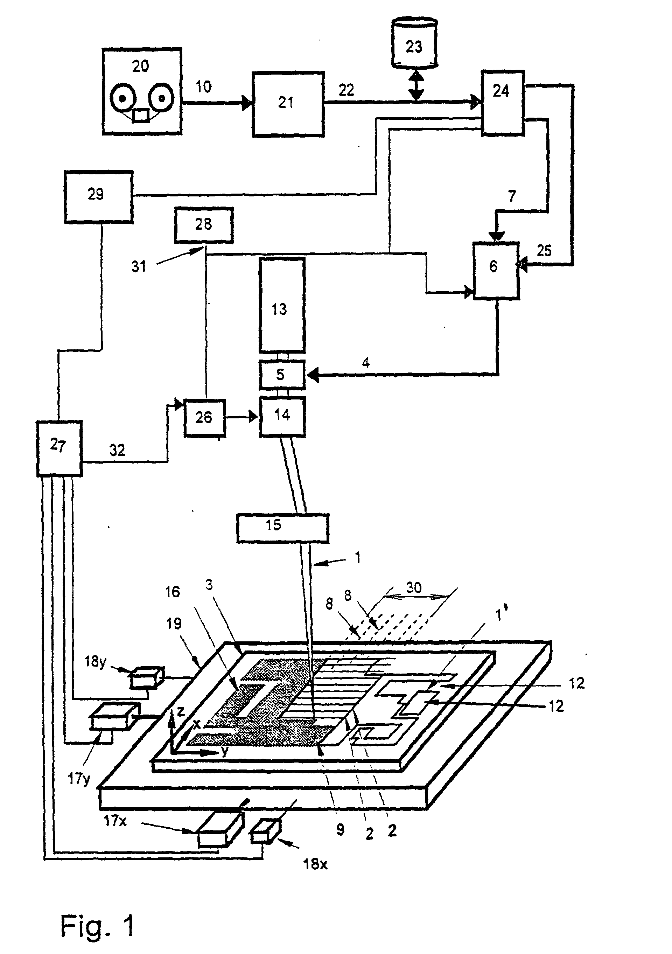

With reference now to the preferred embodiment shown in Fig. 1, the repeated loading of Run Length Encoded (RLE) data items into a modulator driver logic means 6 occurs at a rate which is normally lower than the pixel rate. Data loading occurs at the rate of a data delivery clock which has a clock speed which is compatible with standard IC families, for example FAST-TTL. Two data items can be combined to provide a data word for effective use of the available bits. The modulator driver logic means 6 separates the power and change position fields at the input and supplies a modulation means 5 with the power control signal after a time which is derived from one or both of the last position fields. If the data delivery clock is of a frequency which is lower than the pixel rate, which is normally the case, the delay in the modulator control signal is not generated by a counter but preferably by selection from the various clock signals with time delays between them.

The beam power may be modulated either by modulation of the light source or by using a modulator with a continuous light source. It is also possible to provide for a non-linear relationship between the exposure of the outermost pixel at the edge of an element of the structure and displacement of that edge, by using a table lookup or reading procedure or other correction processes. It is also possible to modify the exposure of more than one row of pixels along the edge in order to produce an exposure gradient which is independent of the position in relation to the scan lines.

It is possible for the apparatus and method to be used in such a way that successive pixels, with unchanged power, can be written without more than one control word being generated.

Reference will now be made to Fig. 1 showing a preferred embodiment of an apparatus for producing surface patterns or structures on photosensitively coated supports or substrates. In the illustrated embodiment, the substrate as indicated at 3 is in the form of a glass plate which is covered with a photosensitive coating, for example a photoresist. The glass plate 3 is disposed on an object table 19 which is movable in the X- and Y-directions. A writing head with a focusing lens 15 and a deflector device 14 which is preferably in the form of an acousto-optical deflector device is arranged to be stationary in the X- and Y-directions. However the focusing lens 15 is freely movable in the vertical direction (the Z-direction). It is disposed a few microns above the surface of the glass plate 3 on an air cushion. As the air cushion is loaded only with the weight of the focusing lens 15, the height of the air cushion can be kept constant, by virtue of the independence of the Z-co-ordinate, so that the surface of the glass plate always remains in the focal plane, even if the surface is uneven.

A laser beam source 13 produces a laser beam which is modulated in regard to its power and in particular its intensity by a modulator device 5, more especially an acousto-optical modulator device. The focusing lens 15 focuses on the laser beam and forms a focused laser beam as indicated at 1, which is directed on to the surface of the glass plate substrate 3.

For monitoring the positioning of the object table 19, the apparatus has position monitoring devices 18x and 18y which monitor the positioning of the object table 19 in the X- and Y-directions relative to the writing head (deflector device 14 and focusing lens 15). Together with electric motors 17x and 17y, the position monitoring devices 18x and 18y form a servo mechanism which produces the precisely controlled movement of the object table 19.

The servo mechanism which is operative in the X-direction moves the object table 19 by means of the electric motor 17x which is preferably in the form of a linear motor, in the X-direction at a constant speed for producing stripes 30 of a given width when the laser beam 1 scans along the scan lines 2. When a respective stripe 30 is completed, the X-servo mechanism performs a retrace stroke movement into the starting position and the object table 19 is then moved in the Y-direction by the width of a stripe by the electric motor 17y which is also preferably in the form of a stepping motor.

A scanning circuit 26 generates a high frequency deflection signal with linear ramp function. The scanning circuit 26 is connected to the deflector device 14. That arrangement produces linear deflection of the laser beam 1 in the width of the respective stripe 30. The focal spot of the focused laser beam 1 is deflected on the surface of the glass plate 3 along the scan lines 2 which extend normal to the longitudinal extent of the stripes 30. Reference numeral 8 in Fig. 1 identifies the positions of the pixels in the scan lines 2 in a purely diagrammatic fashion, that is to say, not to scale.

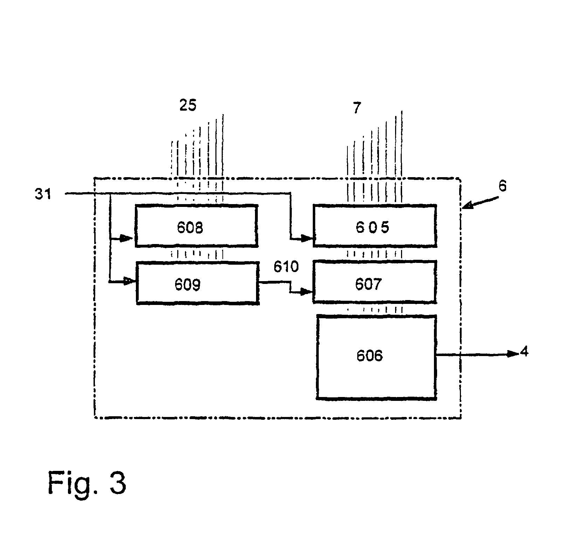

The laser beam source 13 which is for example an HeCd laser generates the laser beam 1 at a preferred wavelength of 442 nm. The laser beam is passed through the acousto-optical modulator 5 which is actuated by a high-frequency modulation drive signal 4. The modulation drive signal 4 is supplied by the modulator driver logic means 6. The intensity or power of the modulation drive signal 4 is controlled by an analog modulation drive signal of a digital-analog converter. The digital-analog converter which is disposed in the modulator driver stage or logic means 6, as shown in Fig. 3, is controlled by a power control signal 7 by way of a storage device which is preferably in the form of a register, for storage of the digital power control word required for producing the control effect.

Reference will be made at this point to Fig. 3 showing a preferred embodiment of the modulator drive logic means 6 described above with reference to Fig. 1. It has two storage devices for bit words, in the form of registers 605 and 608. The register 605 is loaded with intensity or power data 7 coming from the data delivery device 24 shown in Fig. 1. The register 608 is loaded with position or delay data 25 which also come from the data delivery device 24. That takes place on the basis of a transition caused by the clock signal 31. In that arrangement, a digital-analog converter 606 is also operated by power data previously stored in the storage device 607. It may also be in the form of a register. A digitally controlled delay circuit 609 transfers the clock signal 31 to its output side, with a delay which depends on the data stored in the register 608. After that delay the active edge of the clock signal is supplied at the output 610 of the delay circuit 609. The value stored in the register 605 is loaded into the register 607 and passed to the input side of the digital-analog converter 606. After an internal delay in the digital-analog converter 606, a fresh analog power control signal 7 occurs at the output of the modulator driver stage of the modulator device 5.

Going back now to Fig. 1 in which it will be noted that the thick arrowed lines represent the flow of data relating to the structure and the thin lines represent the lines for the control signals, the Fig. 1 embodiment further includes the writing control unit 29 which can be in the form of a processor. The control unit 29 initiates the operation of reading the data from a storage device 23 and sends instruction or command signals to an XY-servo control unit 27 for controlling the movement of the object table 19. A clock generator 28 generates the clock signal 31 which synchronizes operation of the data delivery logic means or device 24, the modulator driver logic means 6 and the deflector circuit 26. The servo control device 27 further supplies a separate readiness signal 32 to the deflector circuit 26. That readiness signal 32 ensures that operation of the deflector device 14 does not occur until the object table 19 reaches its correct X-position. That provides for accurate positioning of the object table 19, in regard to the deflector device 14. As the modulator device 5 and the deflector device 14 operate in an inertia-free fashion and are driven by the same clock signal 31, that arrangement provides a high degree of positional accuracy.

The XY-servo control unit 27 thus co-operates in timed relationship with the servo system 17x, 17y, 18x, 18y and the deflector circuit 26, so as to ensure that the scan line stripes 30, scanning in the respective stripe width by the deflector device 14 and modulation by the modulator device 5 are performed synchronously.

The apparatus may also use a plurality of writing beams instead of the single writing beam. Such a procedure then requires a suitable number of modulators, lenses, parallel data paths and so forth.

The position field contains sufficient data to compute an absolute position for a change in power, but the position field is not necessarily encoded as an absolute position. Particularly when using paired power and run length data, run length encoding can be effected either as a spacing in order to retain the current value before the next change, or as a spacing in order to retain the next current value, or as an absolute position at which the next value begins, or as an absolute position at which the next value ends, or as any other adequate encoding. In addition the position field may contain two sub-fields with one sub-field being absolute and another being relative. Instead of the modulator device 5, it is also possible to use a modulated light source, for example a semiconductor laser or a plurality of semiconductor lasers. Still continuing now with the description of the apparatus shown in Fig. 1, a data input device 20 includes input data for the structure as indicated at 9, which is to be produced on the substrate 3. Such data occur in the form of a list of structure or pattern elements 12 and 16 or regular structure formulae or constants so that the structure elements can be computed. The specification of exposure can be standardized to a maximum exposure or implicitly assumed in the case of a single exposure value for all patterns. In all cases X- and Y-length scales, the angle between the axes and the absolute exposure dosage can be modified by the operator, from what is specified in the input data. It is also possible to carry out other data processing operations, for example mirroring, inversion, gray-scale corrections and pre-compensation operations for underetching or proximity effects. The delivery clock may be a single-phase or multi-phase clock and loading of the run length encoding data items may be effected in one register or in two or more registers. The decoding logic may involve a pre-recall operation or other buffers in order to increase operating speed.

For the purpose of increasing operating speed it is also possible to multiply a part of the data paths, for example to provide a plurality of modulator driver logic means, even if only one laser beam is used.

The relative movement as between the writing head and the substrate can be produced by the writing head moving relative to the stationary substrate or vice-versa. It is also possible for the writing head to be moved in one direction and for the substrate to be moved in a direction perpendicular thereto.

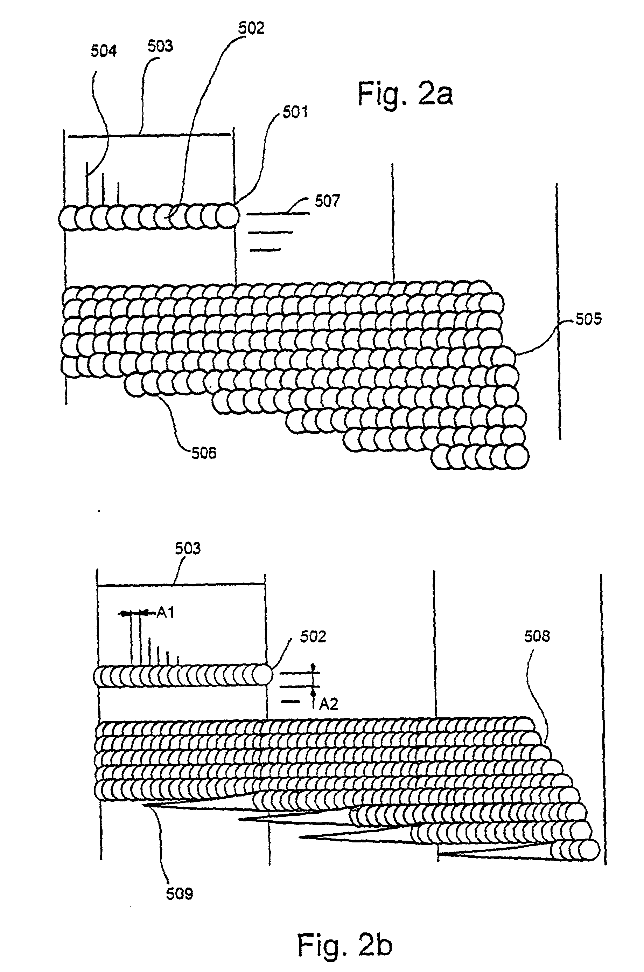

For purpose of further explanation, reference is made to Fig. 2a, which shows a fixed grid with small circles showing the diffraction-limited extent of each pixel. The pixels are centered on a pixel grid 504 and a scan line stripe 503 is formed by successive scan lines indicated at 502. The pixels are centered on the scan line 502 and are arranged at equal spacings from each other. The pixel spacing and the spacing of successive scan lines 506 are the same. Fig. 2a shows an exposed scan line 502 and a region which is filled with pixels and which extends over three stripes 503. That region has an edge 505 which extends inclinedly relative to the vertical and an edge 506 which extends inclinedly relative to the horizontal. With the illustrated structure it is not possible for the edge to be positioned at fractional pixel points so that the inclined edge configuration is of a jagged or ragged configuration.

In contrast, Fig. 2b shows a pixel arrangement in which the pixel density along the scan lines 502 is higher, more specifically by a factor of at least four, than in the direction of the longitudinal extent of the stripes 503 or normal to the scan line 502. That is also indicated in Fig. 2b by the spacings A1 and A2. A1 identifies the spacing of the respective pixel addressing in a scan line 502 while A2 identifies the spacing of the respective scan lines 502 from each other. As can be seen from Fig. 2b, that provides for extremely fine addressing at the vertical edge. It is therefore possible to have a relatively smooth configuration, even in the case of an edge as indicated at 508 which extends inclinedly relative to the vertical.

The power modulation effect also improves an edge 509 which extends inclinedly relatively to the horizontal, as can be clearly seen from Fig. 2b.

In operation, and with reference to Fig. 1, the geometrical properties of the structure 9 to be produced or the structure elements 12, 16, together with their exposure, are specified in the data input means 20 in a format which is transmitted to a data processing device 21. The data processing device 21 provides for conversion of the geometrical data into an intermediate compressed format 22. The compressed format 22 is inputted into a digital storage device 23. The compressed format is also passed to a data delivery device 24 in which the stored data are processed to provide an internal data format comprising a pair of data contents 7 and 25, namely a data content 7 in relation to beam power and a data content 25 in relation to position. The data content 25 may include delay data, as has already been described above with referenced to Fig. 3. The data content 7 in relation to beam power is passed in the form of a power control signal 7 to the modulator driver stage 6 while the data content 25 in relation to position is passed in the form of a position signal 25 to the modulator driver stage 6. The modulator driver stage 6 which is in the form of a logic circuit calls up those data from the data delivery device 24. The modulator driver stage 6 supplies the modulation drive signal 4 which is variable at the pixel points 8 arranged at regular spacings along the scan lines 2 extending normal to the stripes 30.

### 4. Problems with prior art

One important performance criterion in a scanning pattern generator is the ability to print small pattern elements across the boundary between adjacent scan stripes without error. Typically, each stripe is slightly displaced relative the adjacent ones, since they are not written at exactly the same time and any system has some drift and position noise. A mismatch between the patterns on two sides of a stripe boundary is referred to here as butting error. Therefore, if a small pattern element is located across a stripe boundary, a size error of the pattern element will typically occur due to the butting error.

An example of such a size error is provided for purpose of explanation and not limitation. In a 5X photomask for a 0.5 µm VLSI device, the transistor gates are 2.5 µm long. The need for absolute position accuracy in the mask may be 100 nm (three sigma value). But if the stripes are randomly displaced by ±100 nm, somewhere in the mask there can be a relative displacement between two adjacent stripes of perhaps 170 nm. If transistor gates are placed across this stripe boundary, they are dilated by 170 nm, or 7% of 2.5 µm. This size error affects the characteristics of the transistors and can cause malfunction of the entire circuit, or lower the tolerance to other process errors, thus lowering the process yield.

One known method to reduce butting errors is to write several passes with the stripes displaced between the passes. Butting errors are averaged out, but the method is wasteful because essentially the same pattern has to be written several times.

### SUMMARY OF THE INVENTION

The above mentioned problems are overcome with a method and apparatus as defined in claims 1 and 15. Preferred embodiments of the present invention are defined in the respective dependent claims.

With the parallel scan lines forming scan stripes along the substrate, such that the scan lines extend transversely across the respective scan stripe, the invention includes methods and apparatus to suppress the visibility of the end boundaries of the stripes, particularly those end boundaries between adjacent stripes that may otherwise be caused by the apparatus that is used for writing a structure on a photosensitive surface of a substrate. In accordance with the invention, the stripes are made to overlap each other.

According to one aspect of the invention the transition from one stripe to the next is synchronized to the position of feature edges in the data.

According to another aspect of the invention the stripes are blended in the overlap according to a predetermined stepwise changing function. By this method the benefits of the invention can be maintained across the stripe boundaries, which are rendered virtually invisible for all valid input data. This is done with a very small expenditure of increased complexity, data volume, and data preprocessing.

It is to be understood that both the foregoing general description and the following detailed description are exemplary and provided for purposes of explanation only, and are not restrictive of the invention, as claimed. Further objects, features and advantages of the present invention will be apparent from the following description.

### BRIEF DESCRIPTION OF THE DRAWING

The accompanying drawings, which are incorporated in and constitute a part of the specification, illustrate the preferred embodiment of the invention, and together with the description, serve to explain the principles of the invention.

Fig. 1 shows an apparatus for producing a surface pattern or structure according to a prior-art method.

Fig. 2a is a fixed pixel grid.

Fig. 2b shows a pixel arrangement according to prior-art.

Fig. 3 shows an embodiment of a modulator driver logic that can be used in the apparatus of Fig. 1.

Fig. 4 is an illustrative representation of a pattern having an area extending slightly across the stripe boundary that is smaller than the minimum feature size desired.

Fig. 5 is an illustrative representation of an aspect of the invention, wherein the stripe boundary between adjacent stripes is moved for each scan line to eliminate pattern areas that would otherwise be smaller than the desired minimum size.

Fig. 6 is an illustrative representation of another aspect of the invention, wherein the pattern is divided into partially overlapping stripes and the exposure is blended in the overlap by an exposure blend function.

Fig. 7 shows an embodiment of a modulator driver logic of the invention that may be used for blending of overlapping stripes of Fig. 6.

Fig. 8 is a position and time chart, which illustrates the function of the embodiment of Fig. 7.

### DETAILED DESCRIPTION OF PREFERRED EMBODIMENTS

Writing of arbitrary patterns may be performed accurately and efficiently using the above described method and apparatus. Preferably, however, it is desirable that the following two conditions are met. First, the modulator drive signal should only change value once per data clock period. Second, the time between two successive changes in the modulator drive signal should not be smaller than a specific value, referred to hereinafter as the minimum feature size. In accordance with the first condition, features longer than one clock period can always be written regardless their position relative to the grid. The minimum feature size of the second condition, therefore, is generally considered to be one clock period.

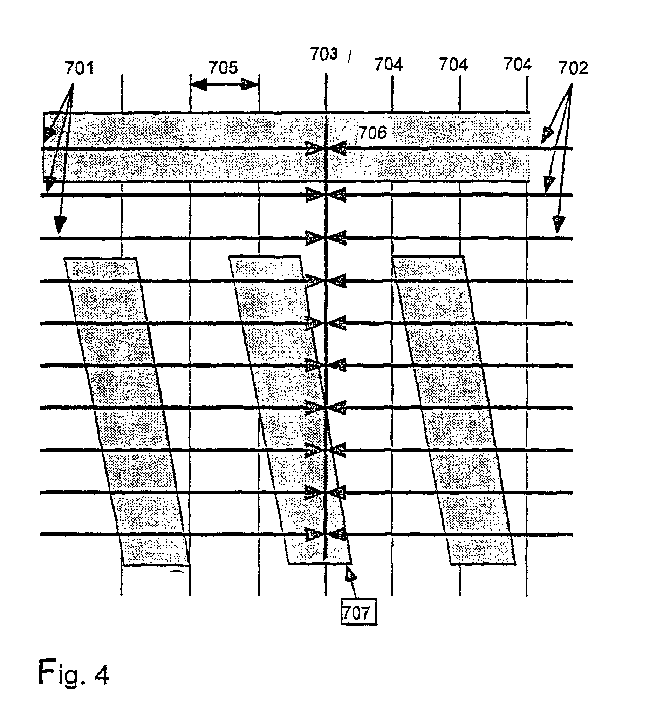

In practice, it is possible that a portion of a pattern will be smaller than the minimum feature size when the pattern is cut or divided into scan stripes. For example, and with reference to Fig. 4 for purpose of explanation, two sets of parallel scan lines 701, 702 form two adjacent scan stripes and share a stripe boundary 703. Positions along the scan line corresponding to the clock pulses are shown as lines 704, and the minimum feature size is equal to one clock cycle 705.
Although a long feature 706 can be divided without problems at the stripe boundary 703, features that protrude only slightly into an adjacent stripe will produce small pattern elements 707 that may violate the minimum feature size condition when divided.

One method used by the assignee of this application to avoid violation of the second condition is to generate features that satisfy the minimum feature requirement and extend outside the scan stripe. An independent gating or window signal is then used to cut the features at the stripe boundary. In this manner, very short pulses can be generated when necessary. However, the low-pass characteristics and non-linearity of the modulator distorts the short pulses, and a pattern like that in Fig. 4 is still difficult to write without visible artifacts.

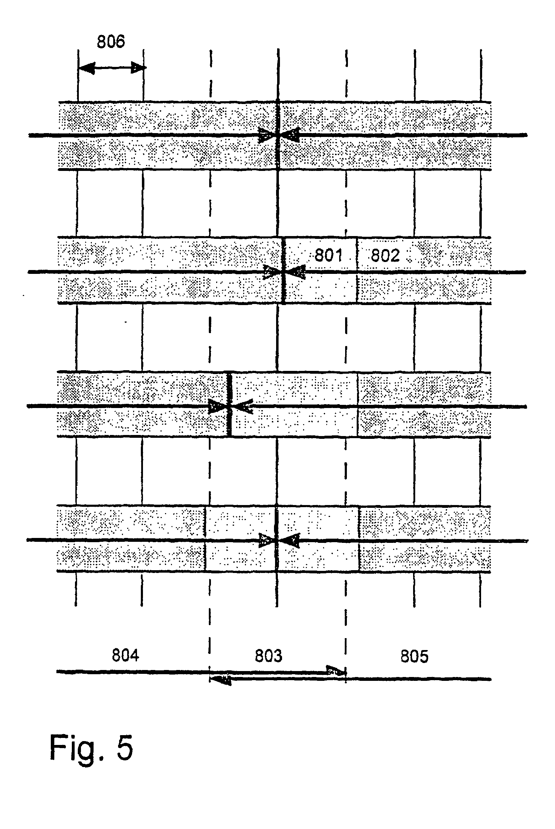

In accordance with an additional aspect of the invention, therefore, the method and apparatus embodied herein prevents any pattern elements smaller than the minimum feature size from being written. Particularly, the method and apparatus of the invention changes the position of the stripe boundary from scan line to scan line depending on the written pattern. Fig. 5 shows the placement of the boundary for a number of cases, wherein the transition between exposed and unexposed elements 801, 802 is performed using different power levels rather than a modulator on-off process. In each case, the boundary is placed so that the exposed and unexposed elements are at least as large as the minimum feature size, so as not to violate the second condition defined above. Fig. 5 further shows that there also may be an overlap 803 of the scan lines 804 and 805 of at least twice the minimum feature size 806. Within this overlap 803, there is either a transition in the modulator drive signal, or the pattern feature is long enough to be cut in two parts satisfying the minimum feature size condition.

In accordance with an important aspect of the invention, a method and apparatus is provided to reduce the influence of butting errors with a minimal loss of through-put. In the invention, a moderate overlap between successive scan stripes is introduced and the stripes are blended in the overlap region. The transition from one stripe to the next is not abrupt, and the butting errors are effectively distributed over the overlap region, typically between about 5 to 10% of the stripe width. Therefore, and with reference to the drawings of the example set forth above, the butting error can be spread out over an overlap of 10 µm. In this manner, a feature that is 2.5 µm will see only one fourth of the total butting error, i.e., 42 nm or less than 2% size error.

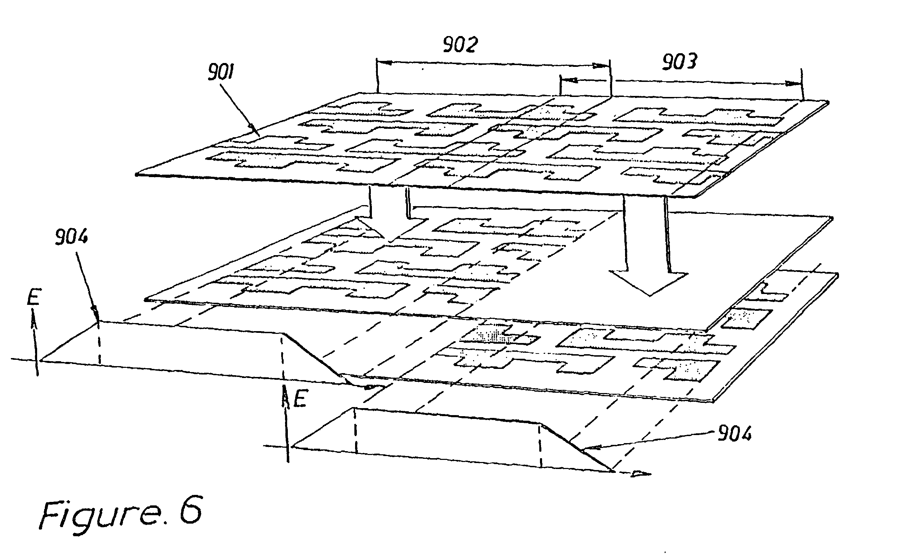

Fig. 6 is a schematic representation of the overlap and blend function of the invention. The pattern data 901 is cut or divided into data stripes 902 and 903, wherein the data stripes 902 and 903 partially overlap each other. An exposure blend function 904 determines the exposure energy along a scan line. The blend function 904 is established so that the data stripes, when blended together, produce an even exposure of the pattern. Specifically, the blend function is used to modulate the exposure level of the pattern data of each data stripe, so that the exposure is the product of the pattern data and the blend function.

To perform the blend function and thus reduce the influence of butting errors, it is possible to let the light beam pass two modulators in series, one for the data and one for the blend function. More convenient, however, is to combine the data and blend function into a single electronic signal that is fed to a single modulator. In this manner, the use of one modulator rather than two allows for better light efficiency, since each modulator has an insertion loss of approximately 20%. Additionally, an optical train having a single modulator is also considerably less complicated, less expensive, and easier to adjust than one having two modulators in series.

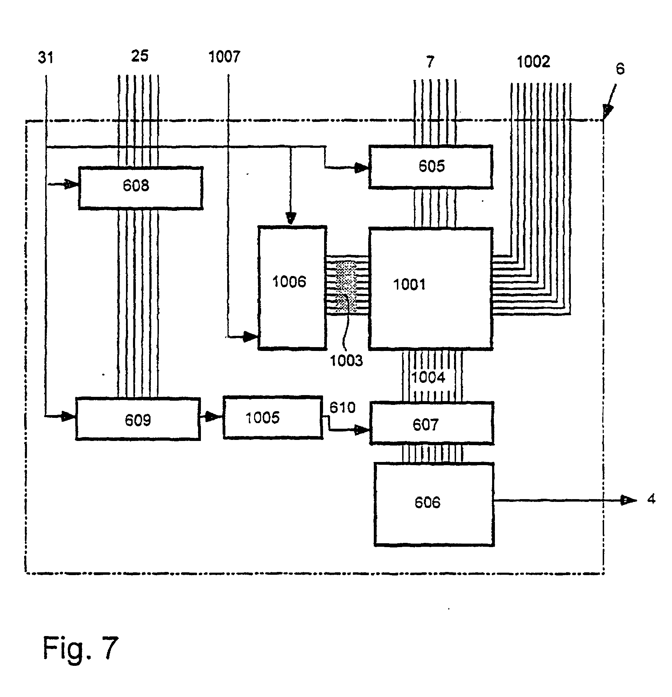

The preferred embodiment of the apparatus used for performing this combined modulation is shown in Fig. 7. This modulator drive logic 6 includes all the same elements as that of Fig. 3, as indicated by the same reference characters, as well as additional elements to perform the exposure blend function.

As noted above, modulator drive signal 4 is produced using both time delay data 25 and power data 7. The exposure blend function is stored in the lookup memory 1001, which can be loaded through the processor interface 1002. The intensity data 7 and the clock count 1003 within the scan line are used to address one cell at a time in the lookup memory 1001. In turn, the lookup memory 1001 outputs for each clock cycle an intensity value 1004 that corresponds to the product of the power blend function and power data and is corrected for the non-linearity of the modulator. Additionally, the time delay circuitry-608, 609, 607 works substantially identically to that of Fig. 3 except the latch 607 is clocked not only when the power input data 7 changes, but at every clock cycle in order to update the digital-analog converter with new values of the exposure blend function.

The cycle count comes from the counter 1006, which counts cycles on the data clock 31 and is reset at the start of every scan line by a start-of-scan pulse 1007. A congestion detector 1005 is added to assure that the minimum feature size condition is not violated, and removes one clock pulse if it is. The removed clock pulse is one that does not refer to a transition in the power data 7. This process causes a variation in the function that is difficult to predict before-hand, but is completely determined by the input data. The patterns in the stripes are identical in the overlap and the circuit works exactly the same in both stripes. The principle is to let the timing of the exposure blending synchronize to the pattern data in a deterministic way so as to have exactly the same pattern in both stripes.

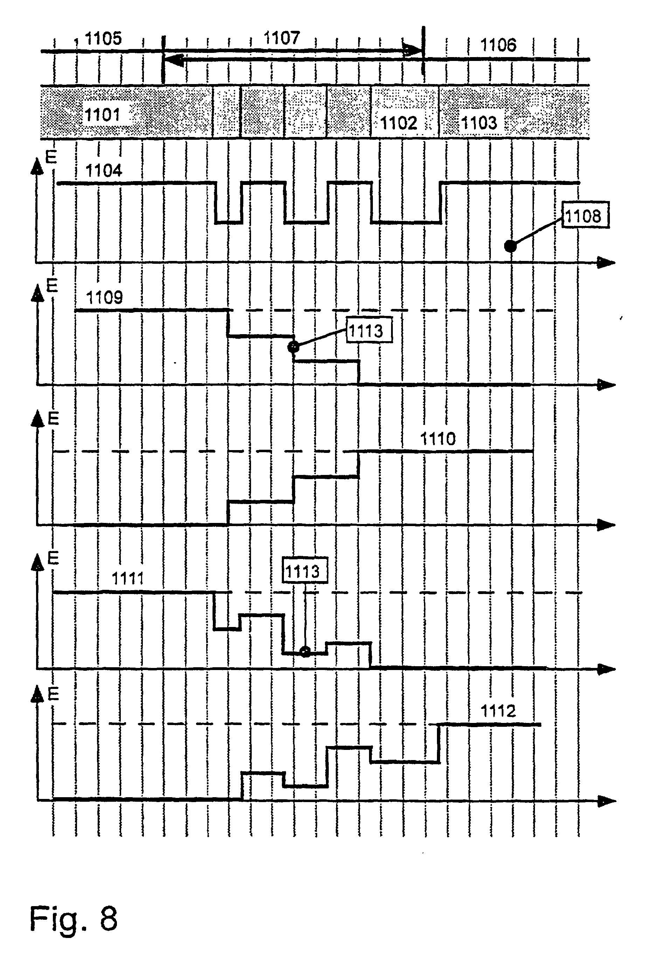

Fig. 8 is a position and time chart, which depicts how two stripes are blended in the overlap region. The pattern to be written 1101 consists of elements with two different exposure levels 1102, 1103. The graph 1104 is the exposure E to be written corresponding to the pattern 1101. The horizontal axis therefore represents both a position axis and a time axis, since the scanning is linear from left to right. The two stripes are shown by the arrows 1105 and 1106, respectively, with the overlap identified by reference character 1107. The vertical lines 1108 in the position and time chart represent the clock pulses.

The right and left ends of the exposure blend function are shown by the graphs 1109 and 1110. Likewise, the value of the modulator drive signal for each of the two stripes is shown by the graphs 1111 and 1112, respectively. It is shown that graph 1111 is the product of 1104 and 1109, while graph 1112 is the product of 1104 and 1110. Additionally, and for purpose of example, it is shown that the steps in 1109 are synchronized within one clock cycle with the steps in the data, except for the step 1113 where the congestion detector has delayed it one more cycle, since it would violate the minimum feature condition described above if it was allowed to occur in its own clock cycle.

When combined, the sum of 1111 and 1112 is equal to 1104. The pattern 1101 corresponding to the data 1104 is therefore blended in the overlap between the stripes 1105 and 1106 by the blend functions 1109, 1110, and the blend function timing is synchronized to the data to produce the modulator drive signals 1111 and 1112. Additionally, the stripes preferably extend two clock cycles outside the region where the blend functions are both non-zero. This is to make sure that the patterns in both stripes are identical and that no end effects alter the synchronization of blend functions to data where there is exposure in both stripes.

The shape of the exposure blend function, the length of the overlap, and the number of steps from 0 to 100% are determined by the system software, and can be made parameters to be input by the user of the pattern generator. For a very critical pattern, the overlap can be increased up to half the stripe width and the number of steps can be increased, while for a less critical job the overlap can be reduced for higher through-put. The contents of the lookup memory are calibrated by measurement of the actual beam power to make the true exposure follow the theoretical blend function.

In a further embodiment of the invention, the exposure blend signal also contains information regarding exposure variations along the scan line, in addition to the information of the blending in the overlap region. By measuring the true exposure along the scan line and adding an appropriate correction to the exposure blend function, any unwanted exposure variations can be removed. The corrections are of a very small magnitude, typically about 2%, and the unpredictability of timing caused by the congestion detector is generally unimportant.

The above described methods with syncronization and blend function can be used separately or combined with each other. The synchronization can hereby depend on boundaries on an exposed surface, or boundaries detected in the input data controlling the beam before the exposure.

It will be appreciated that the above-described description of the present invention has been set forth solely by way of example and illustration of the principles of the present invention and that various other modifications and alterations may be made therein without thereby departing from the scope of the accompanying claims.

## Claims

1. A method for writing on a photosensitive surface a pattern described in input data by scanning at least one modulated laser beam in parallel scan lines while moving along scan stripes in a direction perpendicular to the scan lines, the method comprising the steps of
dividing said input data into partially overlapping stripe pattern data corresponding to scan stripes having stripe overlap regions,
providing a predetermined exposure blend function along the scan line, said blend function starting and ending with a 0% value and further having a 100% value near the center of the scan line, and
modulating the laser beam with the product of the exposure blend function and the stripe pattern data.

2. A method as set forth in claim 1, wherein the exposure blend function has intermediate values in the overlap regions, and preferably two or more such intermediate values.

3. A method as set forth in claim 2, wherein the shape of the exposure blend function is software-controlled and can be changed by the operator.

4. A method as set forth in claim 1, wherein the stripe overlap has a width that is software-controlled and can be changed by the operator.

5. A method as set forth in claim 1, wherein for each laser beam the exposure blend function and the stripe pattern data are combined into a single modulation signal and fed to a single modulator.

6. A method as set forth in claim 5, wherein the data fed to the modulator is applied with pattern-dependent time delays, and further wherein transitions between different values in the exposure blend signal occurring close in time to transitions in the stripe pattern data are synchronized to the timing of the stripe pattern data.

7. A method as set forth in claim 6, wherein the stripe pattern data is at least one clock cycle wider than the region where the exposure blend function is non-zero.

8. A method as set forth in claim 6, wherein a congestion detector monitors the time delay data to indicate when two transitions in the modulator signal occur less than one clock cycle apart, and to change the timing of one of the transitions.

9. A method as set forth in claim 5, wherein the combination is done by table lookup, and the table lookup is calibrated by measurement of laser beam power.

10. A method as set forth in one of the claims 2-9 wherein the boundary between intermediate values in the blend function in the stripe overlap regions, is synchronized according to input data for the pattern in the overlap regions.

11. A method as set forth in claim 10, wherein the synchronization is controlled according to boundaries in the input data before exposure.

12. A method as set forth in claim 10, wherein the synchronization is controlled according to edges in the exposed area to a transition by a modulator drive signal as specified in the input data for the beam.

13. A method as set forth in claim 1, wherein the stripe boundary in a scan line where the writing ends in one stripe and starts in the corresponding scan line in a adjacent stripe, is synchronized to a transition by a modulator drive signal as specified in the input data for the beam.

14. A method as set forth in claim 13, wherein the beam data in the overlapping regions of two stripes are identical and line-by-line synchronization between the stripe boundary and the transitions in the beam data is done by a synchronization circuit at the time of writing.

15. An apparatus for writing patterns described in input data by scanning at least one modulated laser beam in parallel scan lines while moving along scan stripes in a direction perpendicular to the scan lines, the apparatus comprising:
a data preprocessing system for converting the input data to pattern modulation data corresponding to the patterns in partially overlapping stripes, wherein the scan stripes have stripe overlap regions,
a digitally stored exposure blend function having a 0% value at the ends of the scan line, a 100% value near the center of the scan line, and
modulation means for modulating the laser beam with the product of the pattern modulation data and the exposure blend function.

16. An apparatus as set forth in claim 15, where the blend function comprises intermediate values for positions corresponding to the stripe overlap regions.

17. An apparatus as set forth in claim 15, further including
time delay circuitry to delay transitions in the modulation data for higher address resolution than corresponding to the data clock pulses, and
synchronization circuitry to synchronize transitions in the exposure blend function to delayed transitions in the pattern modulation data.

## Patentansprüche

1. Verfahren zum Schreiben einer beschriebenen Struktur auf eine lichtempfindliche Oberfläche, wobei die Struktur als Eingangsdaten durch Führen mindestens eines modulierten Laserstrahls in parallelen Abtastlinien bei gleichzeitiger Bewegung entlang Abtaststreifen in einer Richtung senkrecht zu den Abtastlinien definiert ist, wobei das Verfahren die folgenden Schritte umfasst:
Unterteilen der Eingangsdaten in teilweise überlappende Streifenstrukturdaten entsprechend Abtaststreifen mit Streifenüberlappungsbereichen,
Bereitstellen einer vorbestimmten Belichtungsvermischungsfunktion entlang der Abtastlinie, wobei die Vermischungsfunktion mit einem Wert von 0 % beginnt und endet und weiterhin in der Nähe der Mitte der Abtastzeile einen Wert von 100 % aufweist, und
Modulieren des Laserstrahls mit dem Produkt aus der Belichtungsvermischungsfunktion und den Streifenstrukturdaten.

2. Verfahren nach Anspruch 1, wobei die Belichtungsvermischungsfunktion in den Überlappungsbereichen Zwischenwerte und bevorzugt zwei oder mehr derartige Zwischenwerte aufweist.

3. Verfahren nach Anspruch 2, wobei die Form der Belichtungsvermischungsfunktion von Software gesteuert wird und durch die Bedienungsperson geändert werden kann.

4. Verfahren nach Anspruch 1, wobei die Streifenüberlappung eine Breite aufweist, die durch Software gesteuert wird und von der Bedienungsperson geändert werden kann.

5. Verfahren nach Anspruch 1, wobei die Belichtungsvermischungsfunktion und die Streifenstrukturdaten für jeden Laserstrahl zu einem einzelnen Modulationssignal kombiniert und einem einzelnen Modulator zugeführt werden.

6. Verfahren nach Anspruch 5, wobei die dem Modulator zugeführten Daten mit strukturabhängigen Zeitverzögerungen angewendet werden und wobei weiterhin Übergänge zwischen verschiedenen Werten in dem Belichtungsvermischungssignal, die zeitnah zu den Übergängen in den Streifenstrukturdaten auftreten, mit der Taktsteuerung der Streifenstrukturdaten synchronisiert werden.

7. Verfahren nach Anspruch 6, wobei die Streifenstrukturdaten mindestens einen Taktzyklus breiter sind als der Bereich, wo die Belichtungsvermischungsfunktion von Null verschieden ist.

8. Verfahren nach Anspruch 6, wobei ein Überlastungsdetektor die Zeitverzögerungsdaten überwacht, um anzugeben, wann zwei Übergänge in dem Modulatorsignal um weniger als einen Taktzyklus voneinander beabstandet auftreten, und um die Taktsteuerung einer der Übergänge zu ändern.

9. Verfahren nach Anspruch 5, wobei die Kombination durch Tabellennachschlagen erfolgt und das Tabellennachschlagen durch Messung der Laserstrahlleistung kalibriert wird.

10. Verfahren nach einem der Ansprüche 2-9, wobei die Grenze zwischen Zwischenwerten in der Vermischungsfunktion in den Streifenüberlappungsbereichen gemäss Eingangsdaten für die Struktur in den Überlappungsbereichen synchronisiert wird.

11. Verfahren nach Anspruch 10, wobei die Synchronisierung gemäss Grenzen in den Eingangsdaten vor der Belichtung gesteuert wird.

12. Verfahren nach Anspruch 10, wobei die Synchronisierung gemäss Kanten in dem belichteten Bereich durch ein Modulatoransteuersignal nach Spezifizierung in den Eingangsdaten für den Strahl mit einem Übergang gesteuert wird.

13. Verfahren nach Anspruch 1, wobei die Streifengrenze in einer Abtastlinie, wo das Schreiben in einem Streifen endet und in der entsprechenden Abtastlinie in einem benachbarten Streifen beginnt, durch ein Modulatoransteuersignal nach Spezifizierung in den Eingangsdaten für den Strahl mit einem Übergang synchronisiert wird.

14. Verfahren nach Anspruch 13, wobei die Strahldaten in den überlappenden Bereichen von zwei Streifen identisch sind und die linienweise Synchronisierung zwischen der Streifengrenze und den Übergängen in den Strahldaten durch eine Synchronisierungsschaltung zum Zeitpunkt des Schreibens erfolgt.

15. Vorrichtung zum Schreiben von in Eingangsdaten beschriebenen Strukturen durch Führen mindestens eines modulierten Laserstrahls in parallelen Abtastlinien bei gleichzeitiger Bewegung entlang Abtaststreifen in einer Richtung senkrecht zu den Abtastlinien, wobei die Vorrichtung folgendes umfasst:
ein Datenvorverarbeitungssystem zum Konvertieren der Eingangsdaten in Strukturmodulationsdaten entsprechend den Strukturen in teilweise überlappenden Streifen, wobei die Abtaststreifen Streifenüberlappungsbereiche aufweisen,
eine digital gespeicherte Belichtungsvermischungsfunktion mit einem Wert von 0 % an den Enden der Abtastlinie, einem Wert von 100 % in der Nähe der Mitte der Abtastlinie, und
Modulationsmittel zum Modulieren des Laserstrahls mit dem Produkt aus den Strukturmodulationsdaten und der Belichtungsvermischungsfunktion.

16. Vorrichtung nach Anspruch 15, wobei die Vermischungsfunktion Zwischenwerte für Positionen umfasst, die den Streifenüberlappungsbereichen entsprechen.

17. Vorrichtung nach Anspruch 15, weiterhin mit
iner Zeitverzögerungsschaltung zum Verzögern von Übergängen in den Modulationsdaten für eine höhere Adressenauflösung als den Datentaktimpulsen entspricht und
einer Synchronisierungsschaltung zum Synchronisieren von Übergängen in der Belichtungsvermischungsfunktion mit verzögerten Übergängen in den Strukturmodulationsdaten.

## Revendications

1. Procédé pour imprimer, sur une surface photosensible, un motif décrit dans des données d'entrée en balayant au moins un faisceau laser modulé dans des lignes de balayage parallèles tout en le déplaçant le long de bandes de balayage dans une direction perpendiculaire aux lignes de balayage, le procédé comprenant les étapes consistant à
diviser lesdites données d'entrée en données de motif en bandes qui se chevauchent en partie, correspondant à des bandes de balayages possédant des régions de chevauchement de bandes,
procurer une fonction prédéterminée de nuançage d'exposition le long de la ligne de balayage, ladite fonction de nuançage commençant et se terminant avec une valeur de 0 % et possédant en outre une valeur de 100 % à proximité du centre de la ligne de balayage, et
moduler le faisceau laser avec le produit de la fonction de nuançage d'exposition et des données de motif en bandes.

2. Procédé selon la revendication 1, dans lequel la fonction de nuançage d'exposition possède des valeurs intermédiaires dans les régions de chevauchement, et de préférence, deux valeurs intermédiaires de ce type ou plus.

3. Procédé selon la revendication 2, dans lequel la forme de la fonction de nuançage d'exposition est commandée par un logiciel et peut être modifiée par l'opérateur.

4. Procédé selon la revendication 1, dans lequel le chevauchement de bande possède une largeur qui est commandée par un logiciel et qui peut être modifiée par l'opérateur.

5. Procédé selon la revendication 1, dans lequel, pour chaque faisceau laser, la fonction de nuançage d'exposition et les données de motif en bandes sont combinées en un signal de modulation unique et sont alimentées à un modulateur unique.

6. Procédé selon la revendication 5, dans lequel les données qui alimentent le modulateur sont appliquées avec des retards dans le temps dépendant du motif, et en outre dans lequel des transitions entre des valeurs différentes dans le signal de nuançage d'exposition qui apparaissent à proximité dans le temps à des transitions dans les données de motif en bandes sont synchronisées par rapport au minutage des données de motif en bandes.

7. Procédé selon la revendication 6, dans lequel les données de motif en bandes manifestent une largeur supérieure d'au moins un cycle d'horloge à la région dans laquelle la fonction de nuançage d'exposition n'est pas égale à zéro.

8. Procédé selon la revendication 6, dans lequel un détecteur de congestion surveille les données de retard dans le temps afin d'indiquer la présence de deux transitions dans le signal de modulation, séparées l'une de l'autre à concurrence de moins d'un cycle d'horloge et afin de modifier le minutage d'une des transitions.

9. Procédé selon la revendication 5, dans lequel la combinaison est réalisée par consultation d'une table de référence, la consultation d'une table de référence étant étalonnée par la mesure de la puissance du faisceau laser.

10. Procédé selon l'une quelconque des revendications 2 à 9, dans lequel la limite entre des valeurs intermédiaires dans la fonction de nuançage dans les régions de chevauchement de bandes est synchronisée en fonction des données d'entrée pour le motif dans les régions de chevauchement.

11. Procédé selon la revendication 10, dans lequel la synchronisation est réglée en fonction de limites dans les données d'entrée avant l'exposition.

12. Procédé selon la revendication 10, dans lequel la synchronisation est réglée en fonction des bords dans la zone exposée, par rapport à une transition via un signal d'entraînement de modulateur comme spécifié dans les données d'entrée pour le faisceau.

13. Procédé selon la revendication 1, dans lequel la limite de bande dans une ligne de balayage, dans laquelle l'impression se termine dans une bande et commence dans la ligne de balayage correspondante dans une bande adjacente, est synchronisée par rapport à une transition via un signal d'entraînement de modulateur comme spécifié dans les données d'entrée pour le faisceau.

14. Procédé selon la revendication 13, dans lequel les données de faisceaux dans les régions de deux bandes qui se chevauchent sont identiques et la synchronisation ligne par ligne entre la limite de bande et les transitions dans les données de faisceaux, est réalisée par un circuit de synchronisation au moment de l'impression.

15. Appareil pour imprimer des motifs décrits dans des données d'entrée en balayant au moins un faisceau laser modulé dans des lignes de balayage parallèles tout en le déplaçant le long de bandes de balayage dans une direction perpendiculaire aux lignes de balayage, l'appareil comprenant :
un système de prétraitement de données pour transformer les données d'entrée en données de modulation de motif correspondant au motif dans des bandes qui se chevauchent en partie, les bandes de balayage possédant des régions de chevauchement de bandes,
une fonction de nuançage d'exposition mémorisée par voie numérique, possédant une valeur de 0 % aux extrémités de la ligne de balayage, une valeur de 100 % à proximité du centre de la ligne de balayage, et
un moyen de modulation pour moduler le faisceau laser avec le produit des données de modulation de motif et de la fonction de nuançage d'exposition.

16. Appareil selon la revendication 15, dans lequel la fonction de nuançage comprend des valeurs intermédiaires pour des positions correspondant aux régions de chevauchement de bandes.

17. Appareil selon la revendication 15, englobant en outre :
un ensemble de circuits de retard dans le temps pour retarder des transitions dans les données de modulation pour obtenir une résolution d'adresse supérieure à celle correspondant aux impulsions de synchronisation de données, et
un ensemble de circuits de synchronisation pour synchroniser des transitions dans la fonction de nuançage d'exposition par rapport à des transitions retardées dans les données de modulation de motif.
